# EUROPEAN PATENT APPLICATION

(11) **EP 4 679 954 A1**
(43) Date of publication of application: **14.01.2026**
(21) Application number: 24203066.6
(22) Date of filing: 27.09.2024
(51) Int. Cl.: H05K 7/20

(54) **COOLING SYSTEM FOR UNDERWATER DATA CENTER**

(30) Priority: 09.07.2024 KR 20240090515
(71) Applicant: Korea Institute of Ocean Science & Technology, Busan 49111 (KR)
(72) Inventor: HAN, Taek Hee, Busan (KR); PARK, Jun Kil, Busan (KR); CHOI, Young Jin, Busan (KR); PARK, Bom, Busan (KR)
(74) Representative: HGF

(57) **Abstract**

The present disclosure relates to a cooling system for an underwater data center, and according to an aspect of the present disclosure, a cooling system for an underwater data center for cooling a server rack built in a center main body installed underwater may include a first cooling module which includes a first heat exchanger built in the center main body, and a cooling fluid circulation line configured to circulate a cooling fluid in the first heat exchanger inside the center main body and then discharge the cooling fluid to the first heat exchanger.

## Description

### CROSS-REFERENCE TO RELATED PATENT APPLICATION

The present application claims priority under 35 U.S.C. § 119(a) to Korean patent application number 10-2024-0090515 filed on July 9, 2024, in the Korean Intellectual Property Office, the entire invention of which is incorporated by reference herein.

### BACKGROUND OF THE INVENTION

### 1. Field

The present disclosure relates to a cooling system for an underwater data center.

### 2. Description of the Related Art

With the spread of technologies related to the Fourth Industrial Revolution and their application in various industries, the demand for data centers that are able to provide data networking and storage grew at an average annual rate of 10.9% from 2015 to 2020, expected to grow at an average annual rate of 15.9% until 2025.

However, the data center industry is a major carbon emitter, accounting for about 0.8% of global carbon emissions, and 38% of the total power consumption of data centers is for cooling systems in the equipment inside the data centers.

On the other hand, an underwater data center is built in a form in which the data center is constructed on the seabed where the constant temperature and humidity are maintained, such that it is expected to dramatically cut down on the power allocated to the cooling and maintenance systems.

Recently, Microsoft in the U.S. conducted a demonstration experiment on the underwater data center on the seabed in Scotland through the "Natick" project, and as a result of operation for two years, it was found that the underwater data center may enable operation of data centers that are stable and economically feasible with a failure rate of 1/8 over that of a general data center on the ground.

In order to further reduce the energy consumption of underwater data centers, it is crucial to induce heat exchange between seawater and data centers.

However, the underwater data center that cools down with involvement of seawater inflow requires filters to prevent foreign substances from entering upon introduction of the seawater, and due to the characteristics of seawater, frequent replacement of filters and cleaning of the inside of pipes may be necessary due to the inflow and adhesion of various marine fouling organisms such as barnacles.

Accordingly, the present inventors have completed the present invention after a long period of research and trials, in an attempt to develop a cooling system for an underwater data center that enables consistent use of the cooling system with no need to apply or maintain anti-fouling systems for marine fouling organisms by applying a closed cooling system and using clean water or refrigerants with excellent heat exchange efficiency.

### SUMMARY OF THE INVENTION

Embodiments of the present disclosure provide a cooling system for an underwater data center that is installed in a center main body built with a server rack and configured to cool the server rack using a cooling fluid that circulates a cooling fluid circulation line and/or cooling blow of a server fan.

However, unspecified other objects of the present disclosure will be further considered within a range that may be easily inferred from the following detailed description and effect thereof.

According to an embodiment of the present disclosure, a cooling system for an underwater data center which cools a server rack built in a center main body installed underwater may include a first cooling module which includes: a first heat exchanger built in the center main body; and a cooling fluid circulation line configured to circulate a cooling fluid in the first heat exchanger inside the center main body and then discharge the cooling fluid to the first heat exchanger.

Further, the first heat exchanger may be configured to enable heat conduction with seawater through an outer surface of the center main body while being tightly fixed to an inner surface of the center main body.

The cooling fluid circulation line may be arranged in a vertical zigzag structure inside the server rack to provide cooling.

In addition, the cooling system for the underwater data center may include a second cooling module which includes: a first server fan which blows air to the server rack; and a second server fan which sucks in heated air generated from the server rack and blows out the air.

The second cooling module may be configured to allow the blowing of the second server fan to convect internal air of the center main body and blow cooling air from the first server fan.

According to the present disclosure, a cooling system for an underwater data center may cool a server rack by using seawater flowing outside a center main body while being built in the center main body which is installed in a closed state underwater, and provide a practical effect such as enhancement in a cooling efficiency in the center main body through cooling by heat conduction of seawater while convecting and circulating air in the center main body.

On the other hand, even if effects are not explicitly mentioned herein, it is noted that the effects described in the following specification and the potential effect thereof which are expected by the technical features of the present disclosure are considered as described in the present specification.

### BRIEF DESCRIPTION OF THE DRAWINGS

FIG. 1 is a state diagram illustrating a state in which a cooling system for an underwater data center according to an embodiment of the present disclosure is installed.
FIG. 2 is a side view diagram illustrating a state in which a cooling system for an underwater data center according to an embodiment of the present disclosure is installed.
FIG. 3 is a partial configuration diagram illustrating a cooling system for an underwater data center according to an embodiment of the present disclosure.
FIG. 4 is another partial configuration diagram illustrating a cooling system for an underwater data center according to an embodiment of the present disclosure.
FIG. 5 is a state diagram illustrating a state in which a cooling system for an underwater data center according to other embodiments of the present disclosure is installed.
FIG. 6 is a state diagram illustrating a state in which a cooling system for an underwater data center according to an embodiment of the present disclosure is installed.
FIG. 7 shows temperature distribution images explaining heat dissipation and cooling effects by external seawater in a cooling system for an underwater data center according to the present disclosure.
FIG. 8 shows temperature distribution images explaining cooling effects according to the flow rate of seawater flowing in a direction perpendicular to the axial direction of a center main body in a cooling system for an underwater data center according to the present disclosure.
FIG. 9 shows temperature distribution images explaining the cooling effects by a flow rate of seawater flowing in an axial direction of a center main body in a cooling system for an underwater data center according to the present disclosure.
FIG. 10 shows graphs illustrating a correlation between a flow rate of seawater and an internal temperature of a center main body, explaining the cooling effects by the flow rate of seawater in a cooling system for an underwater data center according to the present disclosure.

It is to be understood that the accompanying drawings are provided for reference only to help understand the technical idea of the present invention, and the scope of the rights of the present invention is not limited thereby.

### DETAILED DESCRIPTION

In describing the present invention, if it is judged that related known functions that are obvious to those skilled in the art may unnecessarily obscure the gist of the present invention, the detailed description will be omitted.

The terms used in the present application are intended to be used only to describe particular embodiments, not limiting the present invention. Singular expressions include plural expressions unless the context clearly indicates otherwise. In this application, it should be understood that the terms such as "comprise", "include" or "have" as used herein are to designate the presence of features, numbers, steps, operations, components, parts, or combinations thereof set forth in the specification, and not to preclude the possibility of the presence or addition of one or more other features or numbers, steps, operations, components, parts, or combinations thereof.

The size and thickness of each configuration shown in the diagram are arbitrarily presented for ease of description, and therefore the present invention is not necessarily limited to what is illustrated.

Hereinafter, a cooling system for an underwater data center according to the present disclosure will be described in detail with reference to the accompanying drawings, and in describing by referring to the accompanying drawings, identical or corresponding components will be given with the same reference numerals, and duplicate descriptions thereof will be omitted.

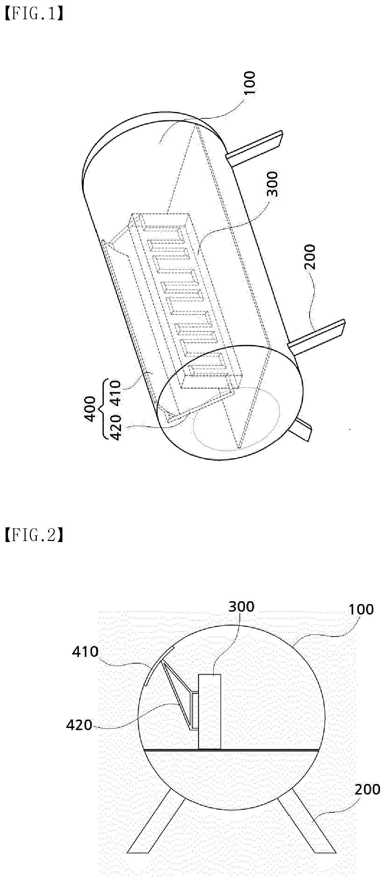

FIG. 1 is a state diagram illustrating a state in which a cooling system for an underwater data center according to an embodiment of the present disclosure is installed, and FIG. 2 is a side view diagram illustrating a state in which the cooling system for the underwater data center according to an embodiment of the present disclosure is installed.

As shown in FIGS. 1 and 2, the cooling system for the underwater data center according to an embodiment of the present disclosure may include a first cooling module 400 configured to cool a server rack 300 which is built in a cylindrical center main body 100 installed underwater and accommodates a server for data processing.

Here, the first cooling module 400 may include a first heat exchanger 410 and a cooling fluid circulation line 420 and be configured to allow a cooling fluid cooled in the first heat exchanger 410 to cool the server rack 300 while flowing along the cooling fluid circulation line 420.

In particular, the cooling fluid circulating in the first cooling module 400 along the first heat exchanger 410 and the cooling fluid circulation line 420 may be clean water or a refrigerant with excellent heat exchange efficiency.

The first heat exchanger 410 of the first cooling module 400 may be configured to perform cooling by allowing the cooling fluid to flow in and out, and more specifically, the cooling fluid may be applied to be cooled by seawater.

The first heat exchanger 410 of the first cooling module 400 may be provided to be in close contact with an inner surface of the center main body 100 that is manufactured in a cylindrical shape and operate to allow the introduced cooling fluid to cool by using the temperature of seawater transferred through an inner surface of the center main body 100.

The center main body 100 of the underwater data center may be provided to be fixed to the seabed by a supporter 200, and a cylindrical outer peripheral surface may be configured to achieve heat conduction to an inner peripheral surface as it comes in contact with seawater.

The first heat exchanger 410 of the first cooling module 400 may be fixed to be in close contact with the inner surface of the center main body 100 where the temperature of seawater is conducted, and have a plurality of corrugated tubes that form a flow path for the cooling fluid, wherein each corrugated tube may be formed to maximize a contact area with the inner surface of the center main body 100 where the temperature of seawater is conducted by joining a heat dissipation fin.

Consequently, the first heat exchanger 410 of the first cooling module 400 may operate to allow the cooling fluid introduced through the cooling fluid circulation line 420 to circulate along a plurality of corrugated tubes built therein so as to achieve cooling by heat dissipation by means of the heat dissipation fin.

However, the first heat exchanger 410 of the first cooling module 400 according to the present disclosure should operate to cool the cooling fluid through heat exchange with seawater while coming close contact with the inner surface of the center main body 100, such that it may have various configurations therefor and is not limited to the configuration proposed above.

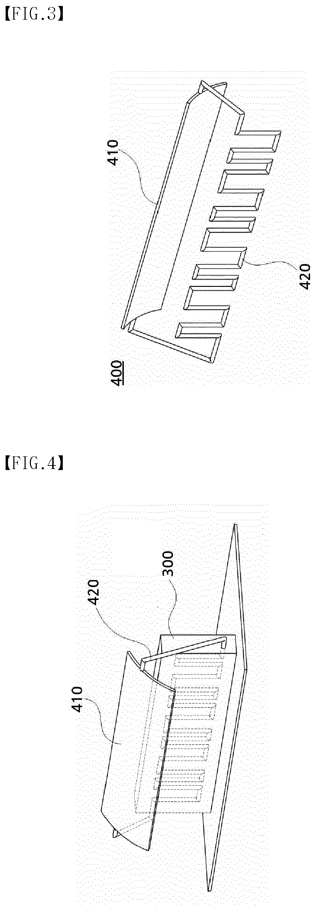

FIG. 3 is a partial configuration diagram illustrating the cooling system for the underwater data center according to an embodiment of the present disclosure, and FIG. 4 is another partial configuration diagram illustrating the cooling system for the underwater data center according to an embodiment of the present disclosure.

As shown in FIGS. 3 and 4, the first heat exchanger 410 of the first cooling module 400 allows the cooling fluid that is cooled down while circulating the corrugated tube built therein to be supplied through the cooling fluid circulation line 420.

Here, the cooling fluid circulation line 420 of the first cooling module 400 may be arranged to penetrate the inside of the server rack 300 in which the server for data processing is accommodated.

More specifically, the cooling fluid circulation line 420 in the first cooling module 400 may be arranged in a vertical zigzag structure inside the server rack 300 and operate to cool the heat generated in the server rack 300 as the cooling fluid is supplied from the first heat exchanger 410 and circulates along the cooling fluid circulation line 420.

At this time, the cooling fluid circulating along the cooling fluid circulation line 420 of the first cooling module 400 may conduct the cooling heat while passing through the inside of the server rack 300 in a vertical zigzag and act to circulate the first heat exchanger 410 while being heated by the heat generated from the server rack.

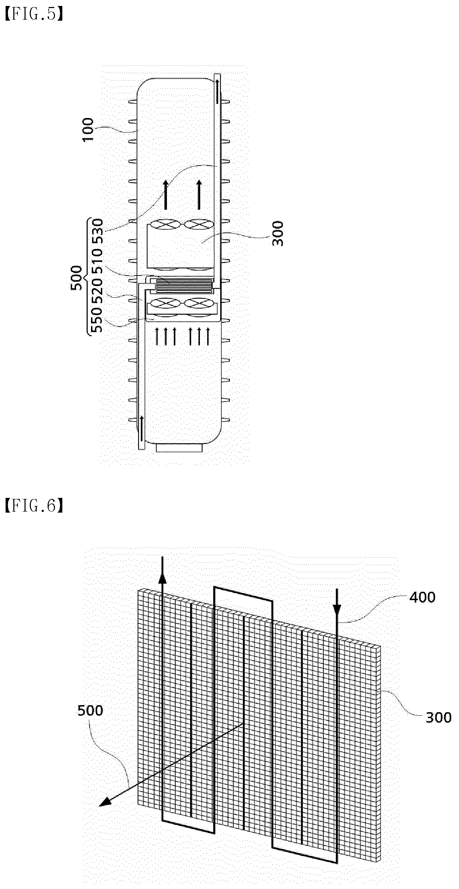

On the other hand, FIG. 5 is a state diagram illustrating a state in which the cooling system for the underwater data center according to another embodiment of the present disclosure is installed.

As shown in FIG. 5, the cooling system for the underwater data center according to another embodiment of the present disclosure may include a second cooling module 400 configured to cool the server rack 300 which is built in the cylindrical center main body 100 and accommodates the server for data processing.

The second cooling module 500 may operate to enhance a cooling efficiency of the server rack 300 by convecting the internal air of the center main body 100.

In other words, the second cooling module 500 may be equipped with a first server fan 510 in front of the server rack 300 and a second server fan 520 in the rear of the server rack 300.

The first server fan 510 and the second server fan 520 of the second cooling module 500 may operate to cool the server rack 300 while being installed to be positioned in front and rear of the server rack 300.

The first server fan 510 and the second server fan 520 of the second cooling module 500 may circulate the internal air of the center main body 100 for convection.

More specifically, the first server fan 510 and the second server fan 520 in the second cooling module 500 may forcibly circulate the internal air of the center main body 100 in a process of cooling the server rack 300 through blowing.

The blowing by the second server fan 520 in the center main body 100 reaches a high temperature state by being heated by heat from the server rack 300, but the air that is cooled by the cooling heat of the seawater transmitted from an inner wall of the center main body 100 may descend and convect in a cooled state.

As such, the internal air of the center main body 100 is forcibly circulated and convected by the first server fan 510 and the second server fan 520 of the second cooling module 500 and cooled by the heat conduction of seawater in the process of convection to reach the optimum temperature of 18°C or less.

The first server fan 510 in the second cooling module 500 may perform cooling by blowing, to the server rack 300, cooling air that is cooled to the optimum temperature of 18°C by air circulation in the center main body 100.

At this time, the server rack 300 may achieve the cooling efficiently by the cooling air blowing from the first server fan 510 of the second cooling module 500.

Here, the second server fan 520 of the second cooling module 500 may operate to discharge air by sucking the air heated by heat conduction in the server rack 300.

While a large amount of heated air is generated in the process of cooling the server rack 300 by the cooling air blowing from the first server fan 510 of the second cooling module 500, this heated air may significantly reduce the cooling efficiency of the server rack if the air is stagnant.

Thus, in the present disclosure, the second server fan 520 of the second cooling module 500 may be used to discharge the heated air of the server rack 300.

As such, the second server fan 520 in the second cooling module 500 may be configured to suck in and blow out hot air discharged to the rear side of the server rack 300 in real time.

Eventually, the hot air generated in the server rack 300 is eliminated in real time by the second server fan 520 in the second cooling module 500, thereby enhancing the cooling efficiency of the server rack.

Further, the second server fan 520 in the second cooling module 500 may suck in and blow out the heated air of the server rack 300, and convention may be achieved as the blown heated air ascends and then descends while being cooled by the cooling heat of the seawater transmitted to the inner wall of the center main body.

FIG. 6 is a state diagram illustrating a state in which the cooling system for the underwater data center according to the present disclosure is installed.

As shown in FIG. 6, the server rack 300 which generates a lot of heat while accommodating the server for data processing may be cooled by conducting cooling heat from the cooling fluid of the first cooling module 400.

In addition, the first server fan 510 in the second cooling module 500 may operate to cool the server rack 300 by blowing, to the server rack 300, the internal air of the center main body 100 that may be cooled to the optimum temperature of 18°C or less.

Furthermore, the second server fan 520 of the second cooling module 500 may operate to blow in real time by sucking the heated air of the server rack 300 generated in the cooling process by the blowing of the first server fan 510, thereby increasing the cooling efficiency of the server rack and achieving the cooling by heat conduction by convecting air in the center main body 100.

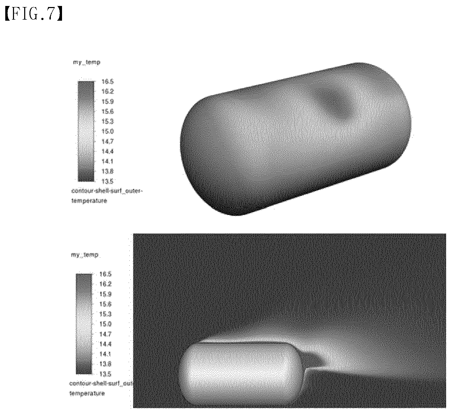

FIG. 7 shows temperature distribution images explaining heat dissipation and cooling effects by external seawater in the cooling system for the underwater data center according to the present disclosure.

As shown in FIG. 7, the heat in the center main body 100 may be conducted into seawater through the outer peripheral surface of the center main body, and the seawater may act to cool while coming in contact with the outer peripheral surface of the center main body.

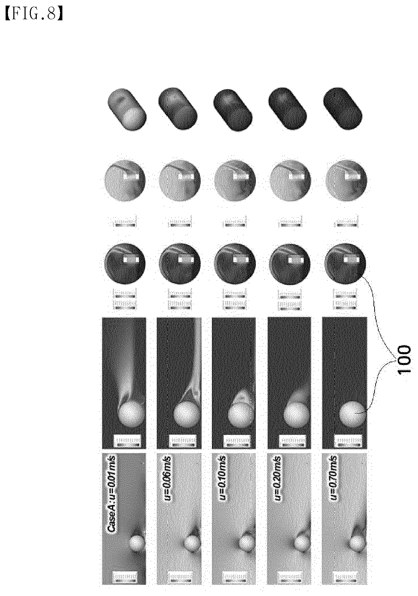

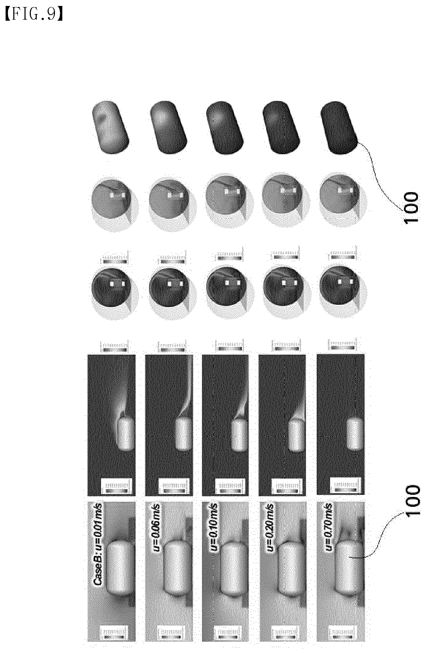

FIG. 8 shows temperature distribution images explaining cooling effects by a flow rate of seawater flowing in a direction perpendicular to an axial direction of the center main body in the cooling system for the underwater data center according to the present disclosure, and FIG. 9 shows temperature distribution images explaining the cooling effects by a flow rate of seawater flowing in an axial direction of the center main body in the cooling system for the underwater data center according to the present disclosure.

As shown in FIGS. 8 and 9, it is found that, as the rate of seawater (u) rises from 0.01 m/s to 0.70 m/s, the red color distributed on the outer peripheral surface of the center main body 100 decreases.

Thereby, it can be seen that there is a proportional relationship in that the cooling effect also increases with the increase in the flow rate of seawater flowing outside the center main body 100.

However, as shown in FIGS. 8 and 9, it is found that the flow direction of seawater flowing outside the center main body 100 is not related to the cooling effect of the center main body.

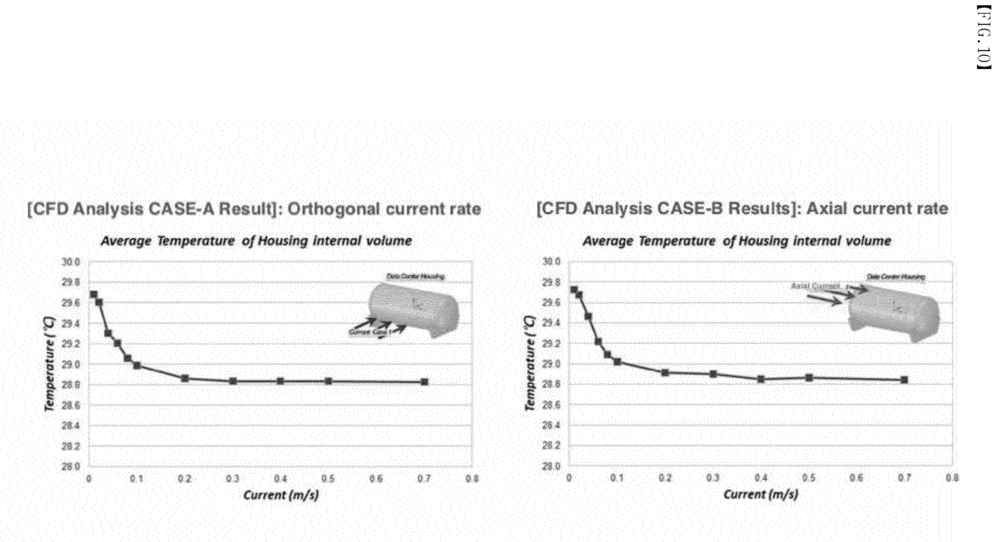

FIG. 10 shows graphs illustrating a correlation between the flow rate of seawater and the internal temperature of the center main body, explaining the cooling effects by the flow rate of seawater in the cooling system for the underwater data center according to the present disclosure.

As shown in FIG. 10, it is found that when the flow rate of seawater reaches 0.20 m/s or higher, it converges to a certain temperature (e.g., 28.8°C), thereby showing that the cooling effect of the center main body 100 is also constant when the flow rate of seawater exceeds a certain rate.

The scope of claims of the present disclosure is not limited to the description and expression of embodiments explicitly described above. In addition, it is mentioned once again that the scope of protection of the present invention is not limited by obvious modifications or substitutions in the art to which the present invention pertains.

### [Description of Symbols]

100: Center main body
200: Supporter
300: Server rack
400: First cooling module
500: Second cooling module

## Claims

1. A cooling system for an underwater data center which cools a server rack built in a center main body installed underwater, the cooling system comprising a first cooling module which comprises:
a first heat exchanger built in the center main body; and
a cooling fluid circulation line configured to circulate a cooling fluid in the first heat exchanger inside the center main body and then discharge the cooling fluid to the first heat exchanger.

2. The cooling system according to claim 1, wherein the first heat exchanger is configured to enable heat conduction with seawater through an outer surface of the center main body while being tightly fixed to an inner surface of the center main body.

3. The cooling system according to claim 1, wherein the cooling fluid circulation line is arranged in a vertical zigzag structure inside the server rack to provide cooling.

4. The cooling system according to claim 1, comprising a second cooling module which comprises:
a first server fan which blows air to the server rack; and
a second server fan which sucks in heated air generated from the server rack and blows out the air.

5. The cooling system according to claim 1 or claim 4, wherein the second cooling module is configured to allow the blowing of the second server fan to convect internal air of the center main body and blow cooling air from the first server fan.
